Europäisches Patentamt

European Patent Office

Office européen des brevets

(11) Numéro de publication: **0 144 273**
**B1**

## FASCICULE DE BREVET EUROPÉEN

(45) Date de publication du fascicule du brevet:
03.02.88

(21) Numéro de dépôt: **84402494.3**

(22) Date de dépôt: **05.12.84**

(51) Int. Cl.⁴: **H 02 H  3/087,** H 02 H  3/06,
H 03 K  17/08

(54) **Circuit de commande de puissance, à courant continu, avec compte rendu d'état et protection contre les surcharges et les courts-circuits.**

(30) Priorité: **06.12.83  FR 8319465**

(43) Date de publication de la demande:
**12.06.85 Bulletin 85/24**

(45) Mention de la délivrance du brevet:
**03.02.88 Bulletin 88/5**

(84) Etats contractants désignés:
**BE DE FR GB IT NL SE**

(56) Documents cité:
**DE-A-2 648 102**
**DE-A-2 904 959**
**DE-B-2 441 316**
**FR-A-2 254 136**
**FR-A-2 458 106**
**GB-A-2 078 040**

(73) Titulaire: **LA TELEMECANIQUE ELECTRIQUE, 33 bis, avenue du Maréchal Joffre, F-92000 Nanterre (FR)**

(72) Inventeur: **Gohl, Pierre- Paul, Chemin de l'Escours, F-06480 La Colle Sur Loup (FR)**

(74) Mandataire: **Marquer, Francis, 35, Avenue Victor Hugo Résidence Chamfleury, F-78180 Voisins- le-Bretonneux (FR)**

LIBER, STOCKHOLM 1988

## Description

La présente invention concerne un circuit de commande de puissance, à courant continu pouvant notamment convenir, mais non exclusivement, à la commande et/ou à l'alimentation de circuits de puissance d'automatismes.

D'une manière générale, on sait qu'il existe déjà des circuits de ce genre équipés, par exemple, de la façon indiquée dans FR-A-2 254 136, d'un dispositif de protection comportant une porte ET dont une entrée reçoit le signal de commande et dont la sortie commande un amplificateur de sortie. Dans cet exemple, le circuit de sortie de cet amplificateur comporte un organe limiteur d'intensité suivi d'un organe capteur de courant. La tension prélevée aux bornes de cet organe capteur de courant est appliquée à un comparateur à seuil qui commande une bascule. Lorsque cette bascule a été commutée par la détection d'une surintensité, elle transmet des impulsions engendrées par une horloge à l'autre entrée de la porte ET, ce qui a pour effet de découper le courant de sortie, donc de le réduire à une valeur moyenne acceptable pendant l'existence de la surcharge.

Il s'avère qu'un tel dispositif présente les inconvénients suivants:

- l'intervention du limiteur correspond à une perturbation qui provoque la non-exécution ou une exécution partielle du signal logique reçu par la sortie protégée sans que la logique de commande soit informée de ces défauts d'exécution de l'ordre reçu;

- d'autres raisons, telles qu'une défaillance de l'alimentation ou de l'amplificateur de sortie, peuvent provoquer la non-exécution de l'ordre logique reçu sans que la logique de commande en soit informée.

De telles incohérences entre l'état logique et l'état physique des organes d'un automatisme peuvent avoir de graves conséquences qui mettent en danger le système automatisé, voire les personnes à proximité, si aucun dispositif ne permet de détecter et de prendre en compte ces incohérences pour éviter les modes de fonctionnement dangereux.

DE-B-2 441 316 décrit un dispositif de commande pour alimenter une charge par l'intermédiaire d'un amplificateur en fonction d'un signal logique externe de commande. Le dispositif comprend un détecteur à seuil de tension qui fournit un signal logique de non-surcharge à une entrée d'une première porte ET lorsque la tension de déchet de l'amplificateur (c'est-à-dire l'écart entre la tension d'alimentation de l'amplificateur et la tension de sortie de celui-ci) est inférieure à une tension de seuil correspondant à un écart maximum acceptable. L'autre entrée de cette première porte ET reçoit un signal logique qui est l'image du signal de commande appliqué à l'entrée de l'amplificateur, de sorte que cette porte ET fournit, par l'intermédiaire d'une bascule, un signal de compte rendu d'exécution de l'ordre logique appliqué à l'entrée de l'amplificateur. L'entrée de cet amplificateur est reliée à la sortie d'une seconde porte ET qui reçoit en entrée, d'une part, le signal logique externe de commande et, d'autre part, le signal de compte rendu, de sorte que la commande de l'amplificateur est conditionnée par la fonction ET de ces deux signaux. Dans ce dispositif antérieur, en cas de défaillance de l'alimentation de l'étage de sortie, le signal logique image du signal de commande continue d'être transmis au premier circuit logique ET, si bien que le signal de compte rendu ne change pas d'état. En outre, ce dispositif antérieur n'est pas utilisable dans le cas d'une sortie d'automate programmable, pour laquelle un isolement galvanique entre le circuit de commande et l'étage de sortie serait nécessaire.

GB-A-2 078 040 montre un dispositif de commande à courant continu comprenant un amplificateur de sortie, un détecteur à seuil de tension comparant la tension de déchet de l'amplificateur à un seuil et des opto-coupleurs pour transmettre le signal de sortie du détecteur à seuil de tension et le signal de commande de l'amplificateur à un circuit logique.

L'invention a pour but de supprimer les inconvénients des dispositifs antérieurs mentionnés ci-dessus tout en en retenant les avantages.

Pour parvenir à ce résultat, l'invention propose un dispositif de commande de puissance à courant continu pour sortie de structure logique telle qu'un automate programmable, comprenant un étage de sortie muni d'au moins un amplificateur de sortie présentant une entrée reliée à un circuit de commande délivrant un signal logique de commande et une sortie reliée à une sortie du dispositif sur laquelle peut venir se brancher une charge de service, ledit dispositif comprenant en outre un détecteur à seuil de tension qui compare une tension de déchet représentative de l'écart entre la tension d'une borne d'alimentation dudit étage de sortie et la tension de la sortie à un seuil et qui délivre un premier signal de non-surcharge lorsque ladite tension de déchet est inférieure audit seuil, le signal délivré par le détecteur à seuil de tension étant transmis à une entrée d'un premier circuit logique dont une autre entrée reçoit un signal logique image du signal de commande appliqué à l'amplificateur de sortie, ce premier circuit logique fournissant en sortie un signal de compte rendu d'exécution qui change d'état en cas de surcharge de l'étage de sortie, caractérisé en ce que ledit étage de sortie comprend en outre, de façon connue en soi, un limiteur d'intensité limitant le courant de sortie de l'amplificateur, et en ce que ledit signal logique image du signal de commande appliqué à l'amplificateur de sortie n'est transmis au premier circuit logique que lorsque ladite tension d'alimentation est effectivement appliquée à l'étage de sortie de manière que le signal de compte rendu change d'état également en cas de défaillance de l'alimentation de l'étage de sortie, le dispositif comportant à cet effet, entre le circuit de commande et l'étage de sortie, un opto-coupleur comprenant une diode émettrice pour assurer la transmission du signal de compte rendu d'exécution, la diode émettrice faisant partie du premier circuit logique et étant reliée à la borne de tension d'alimentation de l'étage de sortie.

Des modes de réalisation de l'invention seront décrits ci-après, à titre d'exemples non limitatifs, avec référence aux dessins annexés dans lesquels:

La figure 1 est un schéma de principe d'un circuit de commande de puissance selon l'invention;

La figure 2 représente le schéma d'un premier mode de réalisation d'un circuit de commande de puissance selon l'invention;

La figure 3 illustre un second mode de réalisation de l'invention utilisant un limiteur d'intensité simplifié.

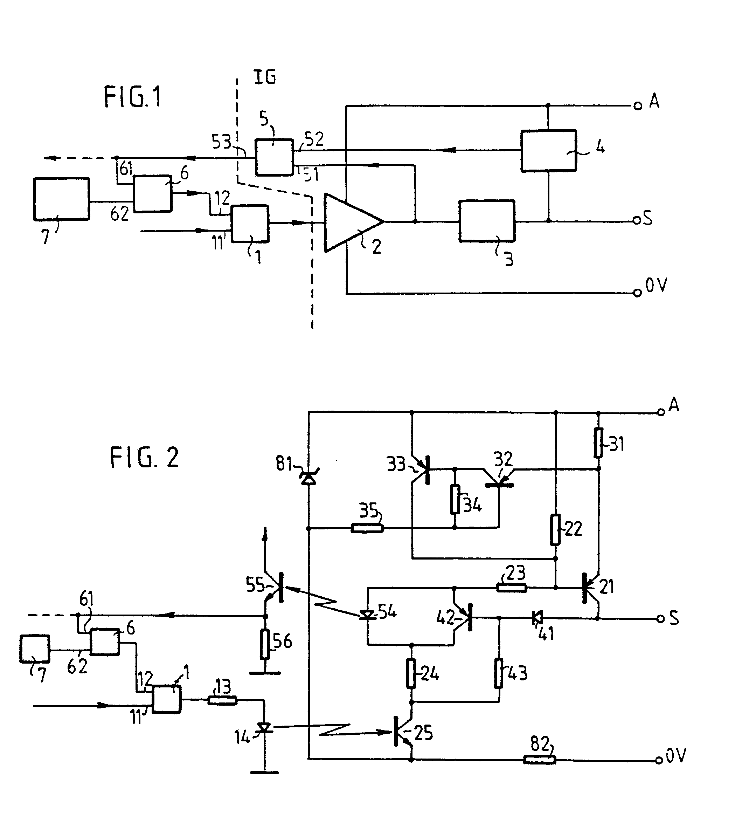

Dans l'exemple représenté sur la figure 1, le signal tout ou rien de commande de ce circuit de sortie est appliqué à l'entrée 11 d'une porte ET 1 à deux entrées dont la sortie est reliée à l'entrée d'un amplificateur de sortie 2; la sortie de cet amplificateur est, d'une part, reliée à une borne de sortie S du dispositif par l'intermédiaire d'un dispositif limiteur instantané d'intensité 3 et, d'autre part, à l'entrée 51 d'une porte ET 5 à deux entrées.

L'amplificateur de sortie 2 est connecté à un circuit d'alimentation (non représenté) par les bornes A et OV. La tension de déchet à l'état "1" du commutateur statique constitué par cet amplificateur 2 est contrôlée par un détecteur à seuil 4 dont la sortie est à "1" lorsque ladite tension de déchet est inférieure au seuil fixé; la sortie de ce détecteur 4 est reliée à l'entrée 52 de la porte ET 5.

La sortie 53 de cette porte ET 5 constitue la borne "compte rendu" d'exécution de l'ordre logique reçu. Cette sortie 53 est, d'une part, accessible à l'utilisateur par exemple au moyen d'un dispositif de connexion non représenté et est, d'autre part, reliée à l'entrée 61 d'une porte OU 6 dont l'autre entrée 62 est reliée à la sortie d'une horloge 7; la sortie de cette porte OU 6 est reliée à l'entrée 12 de la porte ET 1.

Pour utiliser ce type de circuit de sortie dans des structures logiques telles que les automates programmables, il est préférable d'isoler galvaniquement le circuit de sortie des circuits de commande et de contrôle, ce qui est symbolisé par un tireté IG sur le schéma de la figure 1.

Tant que le signal de commande appliqué à l'entrée 11 de la porte ET 1 reste à zéro, l'entrée et la sortie de l'amplificateur 2 restent aussi à zéro, de même que les entrées 51 et 52 de la porte ET 5 dont la sortie 53 reste ainsi à zéro; la porte OU 6 reçoit donc un zéro sur son entrée 61 et un signal cyclique issu de l'horloge 7 sur son entrée 62; la sortie de cette porte OU 6 applique donc ledit signal cyclique à l'entrée 12 de la porte ET 1 dont la sortie reste à zéro tant que son autre entrée 11 reste elle-même à zéro. Lorsque le signal de commande appliqué à l'entrée 11 passe à "1", dès la première coïncidence de ce signal avec un niveau "1" en sortie de l'horloge 7, la porte ET 1 engendre un signal "1" qui rend l'amplificateur de sortie 2 conducteur; en fonctionnement normal de l'amplificateur 2 et en l'absence de tension de déchet excessive entre les bornes A et S, le passage à l'état conducteur de l'amplificateur 2 génère des "1" logiques sur les entrées 51 et 52 de la porte ET 5 dont la sortie 53 reliée à l'entrée 61 de la porte OU 6 passe à "1", ce qui fait passer sa sortie reliée à l'entrée 11 de la porte ET 1 à l'état "1"; le signal de compte rendu d'état disponible à la sortie de la porte ET 5 et transmis par la porte OU 6 à l'entrée 12 de la porte ET 1 assure l'auto-maintien de la commande de l'amplificateur 2 tant que le signal de commande appliqué à l'entrée 11 reste au niveau "1".

Lorsque ce signal de commande passe à zéro, la sortie de la porte ET 1 passe aussi à zéro ce qui bloque l'amplificateur de sortie 2 et remet à zéro le signal de compte rendu fourni via la porte ET 5.

Le comportement de ce dispositif à l'apparition d'un court-circuit de la charge de sortie est alors le suivant: lorsqu'un court-circuit ou une surcharge apparaît pendant que l'étage de sortie est à l'état conducteur, le limiteur d'intensité 3 protège l'amplificateur 2 en écrétant le courant à une valeur instantanée acceptable et l'augmentation de la tension de déchet "$V_A - V_S$" provoquée par cette limitation de courant déclenche le détecteur à seuil 4 dont la sortie reliée à l'entrée 52 de la porte ET 5 passe à zéro, le signal de compte rendu disponible à la sortie 53 de cette porte 5 passe alors à zéro, ce qui, d'une part, informe la logique de commande de l'ensemble de l'automatisme de la non-exécution de l'ordre appliqué à l'entrée 11 et, d'autre part, interrompt le signal d'auto-maintien transmis par la porte OU 6 à l'entrée 12 de la porte ET 1. Par contre, les signaux de l'horloge 7 appliqués à l'entrée 62 de la porte OU 6 parviennent encore à l'entrée 12 de la porte ET 1 et provoquent une conduction périodique forcée de l'amplificateur 2, malgré la surcharge ou le court-circuit, tant que le signal logique appliqué à l'entrée 11 reste au niveau "1". La fréquence et le rapport cyclique du signal généré par ladite horloge 7 sont choisis en corrélation avec le courant de crête fixé par le limiteur 3 de manière à imposer des conditions de dissipation supportables par l'amplificateur de sortie 2.

Dans le cas où le signal logique de commande appliqué à l'entrée 11 passe du niveau zéro au niveau "1" alors que les bornes de sortie S et OV sont déjà en court-circuit ou reliées à une charge d'impédance insuffisante, l'amplificateur 2 se met aussi à conduire dès la première coïncidence avec un niveau "1" du signal de l'horloge 7, ce qui fait passer à "1" l'entrée 51 de la porte ET 5, mais le limiteur 3 intervient et provoque une tension de déchet excessive qui déclenche le détecteur 4 dont la sortie reliée à l'entrée 52 de la porte ET 5 reste à zéro, ce qui maintient à zéro le signal de compte rendu disponible à la sortie 53 de cette porte et empêche donc le passage à "1" du signal d'automaintien précédemment décrit; il s'ensuit que l'amplificateur de sortie 2 ne sera rendu conducteur en présence de cette surcharge ou de ce court-circuit qu'au rythme imposé par l'horloge 7 et tant que le signal logique appliqué à l'entrée 11 reste au niveau "1".

Si la surcharge ou le court-circuit disparaît pendant que la sortie reçoit un signal de commande "1", le limiteur d'intensité 3 cesse d'intervenir, la tension de déchet redevient normale, le détecteur 4 génère alors un signal "1" transmis à l'entrée 52 de la porte ET 5, ce qui permet l'auto-maintien de la commande de l'amplificateur 2 tant que le signal de commande appliqué à l'entrée 11 reste à l'état "1".

Dans le cas d'une défaillance de l'alimentation fournie entre les bornes A et OV pendant que la sortie est à l'état "1", la disparition de tension ne provoque pas de tension de déchet excessive et la sortie du détecteur 4 reste au niveau "1" mais la sortie de l'amplificateur 2 passe à zéro ainsi que l'entrée 51 de la porte ET 5, ce qui fait passer à zéro le signal de compte rendu disponible à la sortie 53 de cette porte et informe ainsi la logique centrale de commande de la non-exécution de l'ordre appliqué à l'entrée 11 de ce circuit.

Dans le cas où la disparition de tension a eu lieu pendant que le signal logique de commande était à zéro, lorsque ce signal passe à "1", l'entrée 51 de la porte ET 5 reste à zéro et maintient donc à zéro le signal de compte rendu disponible à la sortie 53 de cette porte, ce qui permet d'informer la logique centrale de commande de la non-exécution de l'ordre appliqué à l'entrée 11 de ce circuit.

La figure 2 donne le schéma détaillé d'un mode de réalisation de l'invention dont les constituants correspondant aux différentes fonctions du schéma synoptique de la figure 1 portent, soit le même numéro, soit des numéros dont le chiffre des dizaines reprend celui de la fonction correspondante.

L'horloge 7, la porte OU 6 et la porte ET 1 sont agencées entre elles comme sur le schéma synoptique précédemment décrit; la sortie de la porte ET 1 est reliée par une résistance 13 à la diode émettrice 14 d'un photocoupleur dont le phototransistor 25 est relié à la base d'un transistor PNP de sortie 21 par l'intermédiaire d'une résistance 24, d'une diode émettrice 54 et d'une résistance 23 montées en série, dans cet ordre, depuis le collecteur du phototransistor 25 dont l'émetteur est relié au point commun entre l'anode d'une diode Zener 81 et une résistance 82 dont l'autre extrémité est reliée à la borne zéro volt OV prévue pour le pôle correspondant de l'alimentation continue extérieure; la cathode de cette diode Zener 81 est reliée à la borne A prévue pour le pôle positif de ladite alimentation extérieure.

L'émetteur du transistor de sortie 21 est relié à la borne A par l'intermédiaire d'une résistance série 31 et une résistance 22 est montée entre cette borne A et la base de ce transistor 21.

Le collecteur de ce transistor 21 est relié au point commun à l'anode d'une diode 41 et à une borne de sortie S, borne prévue pour le raccordement du point chaud de la charge alimentée par cette sortie, l'autre extrémité de cette charge devant être raccordée à la borne zéro volt OV; la cathode de la diode 41 est reliée par une résistance 43 au point commun à la résistance 24 et au phototransistor 25; le point commun à la diode 41 et à la résistance 43 est encore relié à la base d'un transistor PNP 42 dont l'émetteur et le collecteur sont respectivement reliés à l'anode et à la cathode de la diode émettrice 54.

Un transistor PNP 33 a son émetteur relié à la borne A et son collecteur relié au point commun au transistor 21 et à la résistance 23; la base de ce transistor 33 est reliée au collecteur d'un transistor PNP 32 dont l'émetteur est relié au point commun à la résistance 31 et au transistor 21; la base du transistor 32 est reliée à l'anode de la diode Zener 81 par une résistance 35 et une résistance 34 relie le collecteur et la base du transistor 32.

La diode émettrice 54 fait partie d'un photocoupleur dont le phototransistor 55 est relié au point commun à l'entrée 61 de la porte OU 6 et à une résistance 56 dont l'autre extrémité est reliée au zéro volt de la logique de commande; ce point commun au phototransistor 55 à la résistance 56 et à la porte OU 6 comporte une liaison ou un moyen de connexion avec la logique centrale de commande.

Le fonctionnement du circuit décrit ci-dessus et représenté figure 2 est alors le suivant:

Lorsque ce circuit est normalement alimenté entre ses bornes A et OV, tant qu'il reçoit sur l'entrée 11 de la porte "ET" 1 un signal de commande zéro, la sortie de cette porte reste à zéro, la diode émettrice 14 n'est pas excitée et le phototransistor 25 reste bloqué, de même que les transistors 21, 33, 42 et 55; seul le transistor 32 conduit via les résistances 31, 34 et 35 du fait de la tension appliquée à ce circuit limiteur par la résistance 82 et la diode Zener 81. Lorsque ce même circuit représenté figure 2 reçoit un signal logique "1" sur l'entrée 11 de la porte ET 1, dès la première coïncidence de ce signal avec un niveau "1" en sortie de l'horloge 7, la porte ET 1 engendre un signal "1" qui, via la résistance 13 excite la diode émettrice 14 dont le rayonnement sature le phototransistor 25; si la charge reliée par l'utilisateur entre les bornes S et OV n'absorbe pas un courant supérieur au seuil du limiteur d'intensité 31 à 35 la saturation du transistor 21 par l'intermédiaire des résistances 23 et 24 en série avec la diode émettrice 54 sature le phototransistor 55 qui fait apparaître un niveau "1" à son point commun avec la résistance 56 et l'entrée 61 de la porte OU 6 qui transmet ce "1" à l'entrée 12 de la porte ET 1: comme dans le cas du schéma de principe de la figure 1, on voit que le signal de compte rendu apparaîssant à l'émetteur du phototransistor 55 assure l'auto-maintien de ce circuit de sortie à l'état "1" tant que l'entrée 11 de la porte ET 1 reçoit le signal de commande "1".

Par contre, dès que ledit signal de commande appliqué à cette entrée 11 repasse à zéro, la diode émettrice 14 n'est plus excitée et le phototransistor 25 cesse de conduire, ce qui bloque le transistor 21.

Le fonctionnement du limiteur d'intensité 31 à 35 en régime de conduction normal puis en surcharge du transistor 21 peut s'énoncer comme suit:

En présence d'une charge externe entre les bornes S et OV, lorsqu'un signal logique "1" est appliqué à l'entrée 11 de la porte ET 1, il provoque la saturation du transistor 21 sauf si son courant de base est annulé par la conduction du transistor 33; lorsque le courant de sortie "I" circulant dans la résistance 31 reste inférieur au seuil de limitation de ce circuit, seul le transistor 32 conduit. En effet, en désignant par $V_{BE33}$ le seuil de conduction de ce transistor 33, l'inégalité suivante se trouve réalisée:

$$R_{31} I + V_{CE33} < V_{BE33}$$

$V_{BE33}$ étant la tension base émetteur du transistor 33, $V_{CE32}$, la tension collecteur émetteur du transistor 32 et $R_{31}$ la valeur de la résistance 31.

Il est également possible de définir le seuil de conduction de ce transistor 33 en calculant le courant $I_O$ qui s'établit lorsque le transistor 32 se bloque. Dans ce cas, la relation suivante se trouve réalisée:

$$V_{Z81} = V_{BE33} + I_O (R_{34} + R_{35})$$

$V_{Z81}$ étant la tension aux bornes de la diode Zener 81, $R_{34}$ et $R_{35}$ étant les valeurs respectives des résistances 34 et 35.

De cette relation, on peut déduire l'expression suivante de $I_O$:

$$I_O = \frac{V_{Z81} - V_{BE33}}{R_{34} + R_{35}}$$

Pour que le transistor 33 reste bloqué, il suffit qu'un courant légèrement supérieur à $I_O$ circule dans les résistances 34 et 35 à partir du transistor 32 et de la résistance 31. En reprenant la relation concernant le courant de sortie I:

$$R_{31} I + V_{CE32} < V_{BE33}$$

et, en remplaçant la tension $V_{CE32}$ par une différence équivalente calculée à partir du courant $I_O$, en considérant qu'il fonctionne en amplificateur non saturé ($R_{34} I_O < 0,2$ Volt), et que le gain de ce transistor 32 est assez grand pour rendre le courant de base négligeable par rapport à $I_O$, on obtient:

$$R_{31} I + V_{BE32} - R_{34} I_O < V_{BE33}$$

équation dans laquelle la tension base émetteur du transistor 32 désigne le seuil de conduction de ce transistor. En simplifiant par les tensions base émetteur $V_{BE}$, physiquement très proches, des transistors 32 et 33, on obtient:

$$R_{31} I < R_{34} I_O$$

D'où

$$I < \tfrac{R_{34}}{R_{31}} \times I_O$$

Lorsque le courant de sortie I atteint la limite $I_{max}$ suivante:

$$I_{max} = I_O \times \tfrac{R_{34}}{R_{31}}$$

le transistor 33 se met à conduire et diminue le courant de base du transistor de sortie 21 pour qu'il respecte cette valeur limite; en présence d'une charge de sortie d'impédance trop faible, ce circuit limite donc le courant instantané délivré en désaturant le transistor 21.

Le fonctionnement du circuit de contrôle de tension de déchet de l'amplificateur de sortie associé à son limiteur est le suivant: lorsque l'amplificateur de sortie fonctionne à l'intérieur de ses limites, le transistor 21 est saturé, la diode émettrice 54 conduit ainsi que la diode 41 en série avec la résistance 43 mais le transistor 42 est bloqué.

Par contre, lorsqu'une charge d'impédance insuffisante est alimentée par cet amplificateur de sortie, le limiteur intervient et empêche la saturation du transistor de sortie 21 ce qui abaisse le potentiel de la borne S qui devient inférieur à celui de l'émetteur du transistor 42, la diode 41 cesse de conduire tandis que le transistor 42, saturé par le courant de base circulant dans la résistance 43, court-circuite la diode émettrice 54 qui cesse d'exciter le phototransistor 55 et le signal de compte rendu appliqué à l'entrée 61 de la porte OU 6 passe à zéro, reflétant ainsi la perturbation de l'ordre logique appliqué à l'entrée 11.

Cette annulation du signal de compte rendu supprime l'auto-maintien à l'état "1" de la sortie qui n'est plus commandée que pendant les impulsions de forçage issues de l'horloge 7, transmises par la porte OU 6 et combinées en ET avec le signal de commande par la porte 1: tant que la commande logique et la surchage persistent, ce circuit de sortie fonctionne donc à un régime de découpage dont le courant crête est fixé par le limiteur et dont le rapport cyclique est établi par l'horloge de forçage 7.

Le fonctionnement du circuit représenté figure 2, en cas de défaillance d'alimentation externe, est le suivant:

lorsqu'une panne d'alimentation externe interrompt l'alimentation de la charge connectée à cette sortie alors que le signal de commande appliqué à l'entrée 11 est à "1", ce manque de tension interrompt l'ensemble des courants circulant entre les bornes A et OV donc, en particulier, le courant de la diode émettrice 54; le signal de compte rendu appliqué à l'entrée 61 de la porte OU 6 retombe à zéro, ce qui avertit la logique centrale de la non-exécution de l'ordre appliqué à l'entrée 11 de ce circuit.

On notera que certaines défaillances du circuit de sortie lui-même sont détectables par la logique centrale qui constate les incohérences entre le signal de commande appliqué et le signal de compte rendu renvoyé; par exemple, le non-fonctionnement du transistor 21 malgré un courant de commande au niveau de la diode émettrice 14 et du transistor 25 entraîne l'inhibition du compte rendu par la conduction du transistor 42.

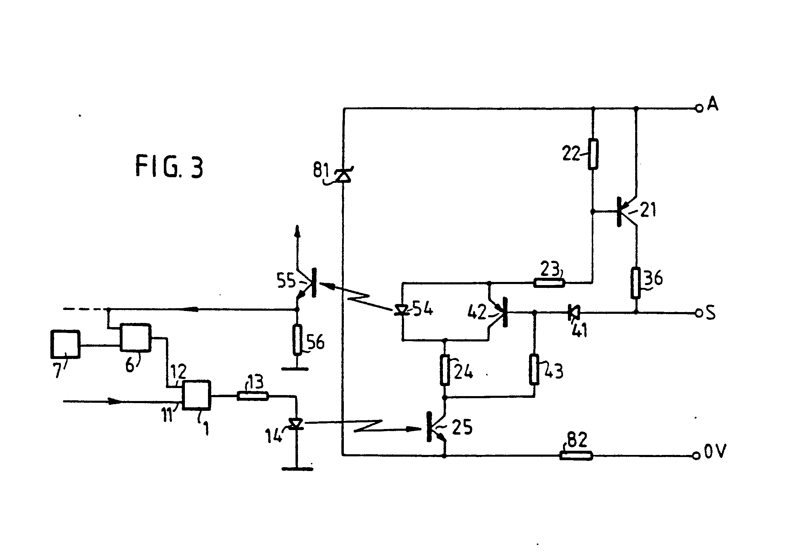

La figure 3 représente une variante du circuit précédent avec un limiteur de courant simplifié à l'extrême puisque réduit à la seule résistance 36; les autres fonctions restent identiques, portent les mêmes références et leur fonctionnement correspond aux explications fournies à propos de la figure 2.

Il convient de noter que l'invention ne se limite pas aux modes de réalisation précédemment décrits. En particulier, le dispositif de commande de puissance selon l'invention pourrait comprendre toute autre combinaison de moyens tels que des réseaux de logique programmable ou des démultiplexeurs permettant, à partir d'un signal logique externe de commande, d'une horloge et dudit signal de compte rendu d'exécution, d'assurer un auto-maintien de la commande de l'amplificateur conformément au fonctionnement précédemment décrit.

En outre, comme précédemment mentionné, le dispositif de commande de puissance selon l'invention peut être avantageusement utilisé dans des structures logiques telles que des automates programmables comprenant par exemple un interface de sortie raccordé au BUS de l'automate, et des cartes de sortie munies de bornes de sortie. Dans ce cas, le dispositif de commande de puissance peut avantageusement être monté entre le susdit interface et les susdite bornes de sortie.

## Revendications

1. Dispositif de commande de puissance à courant continu pour sortie de structure logique telle qu'un automate programmable, comprenant un étage de sortie muni d'au moins un amplificateur de sortie (2) présentant une entrée reliée à un circuit de commande délivrant un signal logique de commande et une sortie reliée à une sortie (S) du dispositif sur laquelle peut venir se brancher une charge de service, ledit dispositif comprenant en outre un détecteur à seuil de tension (4) qui compare une tension de déchet représentative de l'écart entre la tension d'une borne (A) d'alimentation dudit étage de sortie et la tension de la sortie (S) à un seuil et qui délivre un premier signal de non-surcharge lorsque ladite tension de déchet est inférieure audit seuil, le signal délivré par le détecteur à seuil de tension (4) étant transmis à une entrée (52) d'un premier circuit logique ET (5) dont une autre entrée (51) reçoit un signal logique image du signal de commamde appliqué à l'amplificateur de sortie (2), ce premier circuit logique ET (5) fournissant en sortie un signal de compte rendu d'exécution qui change d'état en cas de surcharge de l'étage de sortie, caractérisé en ce que ledit étage de sortie comprend en outre, de façon connue en soi, un limiteur d'intensité (3) limitant le courant de sortie de l'amplificateur (2), et en ce que ledit signal logique image du signal de commande appliqué à l'amplificateur de sortie (2) n'est transmis au premier circuit logique ET (5) que lorsque ladite tension d'alimentation est effectivement appliquée à l'étage de sortie de manière que le signal de compte rendu change d'état également en cas de défaillance de l'alimentation de l'étage de sortie, le dispositif comportant à cet effet, entre le circuit de commande et l'étage de sortie, un opto-coupleur (54, 55) comprenant une diode émettrice (54) pour assurer la transmission du signal de compte rendu d'exécution, la diode émettrice (54) faisant partie du premier circuit logique ET (5) et étant reliée à la borne (A) de tension d'alimentation de l'étage de sortie.

2. Dispositif selon la revendication 1, caractérisé en ce que l'entrée de l'amplificateur de sortie (2) est reliée par l'intermédiaire d'un opto-coupleur (14, 25) à la sortie d'un deuxième circuit logique ET (1) qui reçoit sur ses entrées respectives (11, 12) le signal de commande et le signal de compte rendu d'exécution.

## Patentansprüche

1. Gleichstrom-Leistungskommandoschaltung für den Ausgang einer logischen Anordnung zum Beispiel eines programmierbaren Rechners, mit einer Ausgangsstufe, die mindestens einen Ausgangsverstärker (2) enthält, mit einem Eingang der an Eine Steuerschaltung angeschlossen ist, die ein logisches Steuersignal abgibt und einen Ausgang, der an den Ausgang (S) der Anordnung angeschlossen ist, an welche eine Setriebslast angeschlossen werden kann, wobei besagte Anordnung ausserdem einen Schwellenspannungssensor (4) enthält, der eine Restspannung, die repräsentativ ist für den Unterschied zwischen der Spannung an einer Klemme (A) zur Versorgung der besagten Ausgangsstufe und der Spannung am Ausgang (S) mit einer Schwellenspannung vergleicht und ein erstes Nichtüberlastungssignal abgibt wenn besagte Restspannung geringer ist als besagte Schwellenspannung wobei das vom Schwellenspannungssensor (4) abgegebene Signal an einen Eingang (52) einer ersten logischen AND-Schaltung (5) weitergegeben wird, die an einem anderen Eingang (51) ein logisches Signal erhält, Spiegelsignal des an den Ausgangsverstärker (2) angelegten Signals und diese erste logische AND-Schaltung (5) an ihrem Ausgang ein Ausführungsrückmeldesignal abgibt, dessen Status sich im Falle einer Überlastung der Ausgangsstufe ändert, dadurch gekennzeichnet, dass besagte Ausgangsstufe ausserdem in bekannter Weise einen Strombegrenzer (3) enthält, der den Ausgangsstrom des Verstärkers (2) begrenzt und dass besagtes logisches Signal, Spiegelsignal des an den Ausgangsverstärker (2) angelegten Steuersignals, nur dann an die erste logische AND-Schaltung (5) übermittelt wird, wenn besagte Versorgungsspannung tatsächlich an die Ausgangsstufe angelegt ist, sodass das Rückmeldesignal ebenfalls eine Statusänderung im Falle einer unzureichenden Versorgung der Ausgangsstufe erfährt, wobei die Anordnung zu diesem Zweck zwischen der Steuerschaltung und der Ausgangsstufe ein optoelektronisches Koppelelement (54, 55) mit einer Emitterdiode (54) zur Übermittlung des Ausführungsrückmeldesignals enthält, wobei die Emitterdiode (54) zum ersten logischen AND-Schaltkreis (5) gehört und an die Klemme (A) zur Spannungsversorgung der Ausgangsstufe angeschlossen ist.

2. Anordnung nach Anspruch 1, dadurch gekennzeichnet, dass der Eingang des Ausgangsverstärkers (2) mittels eines optoelektronischen Koppelelementes (14, 25) an den Ausgang einer zweiten logischen AND-Schaltung (1) angeschlossen ist, die an ihren jeweiligen Eingängen (11, 12) das Steuersignal und das Ausführungsrückmeldesignal erhält.

**Claims**

1. A DC power control device for a logic state output such as a programmable controller comprising an output stage provided with at least one output amplifier (2) connected by its input to a control circuit delivering a control logic signal and whose output is connected to an output (S) of the device to which a service load may be connected, said device further comprising a voltage threshold detector (4) which compares a residue voltage representative of the difference between the voltage of a terminal (A) supplying said output stage and the voltage of output (S) with a threshold voltage and which delivers a first non overload signal when said residue voltage is less than said threshold voltage, said signal delivered by said voltage threshold detector (4) being applied to an input (52) of a first circuit (5) providing the logic function AND another input (51) of which receives a logic signal which is the image of the control signal applied to the output amplifier (2), said first logic AND circuit (5) supplying at its output a signal reporting execution which changes state in case of an overload of the output stage, characterized in that said output stage further comprises, in a way known per se, a current limiter (3) limiting the output current of the amplifier (2) and in that said logic signal, image of the control signal applied to the output amplifier (2) is only transmitted to the first logic AND circuit (5) when said supply voltage is effectively applied to the output stage so that the report signal also changes state in case of a failure of supply of the output stage, the device including to this end, between the control circuit and the output stage, an opto-coupler (54, 55) comprising an emitter diode (54) for transmitting the execution report signal, the emitter diode (54) being part of the first logic AND circuit (5) and being connected to the terminal (A) of the supply voltage of the output stage.

2. Device according to claim 1, characterized in that the input of the output amplifier (2) is connected, by means of an opto-coupler (14, 25) to the output of a second logic AND circuit (1) which receives, at its respective inputs (11, 12), the control signal and the signal reporting execution.

FIG.1

FIG. 2

FIG. 3